# EUROPEAN PATENT APPLICATION

(11) **EP 4 700 394 A1**
(43) Date of publication of application: **25.02.2026**
(21) Application number: 23926881.6
(22) Date of filing: 06.04.2023
(51) Int. Cl.: G01R 1/20, G01R 19/32, G01R 19/25, G01R 15/14

(54) **SHUNT, ELECTRIC DEVICE, AND ENERGY STORAGE DEVICE THEREOF**

(30) Priority: 12.03.2023 CN 202310261141
(71) Applicant: C & B Electronics (Shenzhen) Co., Ltd., Shenzhen, Guangdong 518000 (CN)
(72) Inventor: YANG, Baoping, Shenzhen, Guangdong 518000 (CN); LI, Bo, Shenzhen, Guangdong 518000 (CN); WANG, Sanhuai, Shenzhen, Guangdong 518000 (CN); XU, Chengen, Shenzhen, Guangdong 518000 (CN)
(74) Representative: Osterhoff, Utz
(86) International application number: PCT/CN2023/086630
(87) International publication number: WO 2024/187529

(57) **Abstract**

The present application discloses a shunt, an electric device and an energy storage device thereof. The shunt includes a current sampling member. The current sampling member is provided with a first connection segment and a second connection segment. N sampling points are provided on each of the first connection segment and the second connection segment. The N sampling points on the first connection segment and the N sampling points on the second connection segment are symmetrically provided along the midline of the current sampling member; and each of sampling points is led out through an impedance member. The present application aims to improve the detection accuracy of the shunt.

## Description

### CROSS-REFERENCE TO RELATED APPLICATIONS

The present application claims priority to Chinese Patent Application filed to the China National Intellectual Property Administration on March 12, 2023, with the application number 202310261141.8, and entitled "SHUNT, electric device, AND ENERGY STORAGE DEVICE THEREOF", the entire contents of which are incorporated herein by reference.

### TECHNICAL FIELD

The present application relates to the technical field of shunts, and in particular to a shunt, an electric device and an energy storage device thereof.

### BACKGROUND

In a current detection circuit, a shunt is generally used to be connected in series in a circuit loop to be tested. By detecting the voltage at the two connection ends of the shunt connected to the loop and the known impedance of the shunt, the current flowing through the shunt is calculated, thereby obtaining the current value in the circuit loop to be tested.

### SUMMARY

In practical applications, when the shunt is connected in series to the circuit loop to be tested, poor contact often occurs at the two connection ends of the shunt. For example, during welding, bubbles generated during welding cause the circuit loop to be tested and the connection ends of the shunt to be in contact only at partial positions. In the actual working process, this will lead to uneven current density distribution flowing through the shunt, which in turn causes a certain deviation between the sampled voltage value and the actual voltage value when sampling through the above method, thereby affecting the detection accuracy of the shunt.

The main purpose of the present application is to provide a shunt, aiming to improve the detection accuracy of the shunt.

To achieve the above purpose, the present application provides a shunt, which includes:
a current sampling member provided with a first connection segment and a second connection segment, where N sampling points are provided on each of the first connection segment and the second connection segment, and N is greater than 1;
the N sampling points on the first connection segment and the N sampling points on the second connection segment are symmetrically provided along a midline of the current sampling member; and each of the N sampling points is led out through an impedance member.

In an embodiment, a resistance difference between any two impedance members is less than or equal to a preset first resistance difference, and a resistance of any one of impedance members is greater than or equal to 10 milliohms.

In an embodiment, the resistance of any one of the impedance members is less than or equal to 1000 ohms.

In an embodiment, a resistance difference between a resistance of the impedance member connected to any one of sampling points on the first connection segment and a resistance of the impedance member connected to a sampling point on the second connection segment symmetric with the any one of sampling points on the first connection segment is less than or equal to a preset second resistance difference.

In an embodiment, the impedance member is provided with a first end and a second end, and the first end of the impedance member is connected to a corresponding sampling point;
second ends of impedance members connected to all sampling points on the first connection segment are electrically connected to each other; and second ends of impedance members connected to all sampling points on the second connection segment are electrically connected to each other;
or, second ends of impedance members connected to all the sampling points on the first connection segment are provided at intervals from each other; and second ends of impedance members connected to all the sampling points on the second connection segment are provided at intervals from each other.

In an embodiment, a first installation end is further provided on the first connection segment, and the first installation end is spaced apart from sampling points on the first connection segment; and
a second installation end is further provided on the second connection segment, and the second installation end is spaced apart from sampling points on the first connection segment.

In an embodiment, the shunt further includes:
a substrate, where the impedance member is provided on the substrate;
where sampling points on the current sampling member are electrically connected to the substrate through electrical connection wires.

In an embodiment, the current sampling member comprises a current sensing member, a first conductive member and a second conductive member; the first conductive member is the first connection segment; and the second conductive member is the second connection segment; and
the first conductive member and the second conductive member are respectively electrically connected to the current sensing member; and mounting holes are provided on the first conductive member and/or the second conductive member.

In an embodiment, the shunt further includes:
a substrate, where the impedance member is provided on the substrate, and the substrate is mounted on the current sampling member;
where N connection ends corresponding to positions of the sampling points are provided on one side of the substrate facing the current sampling member, and the N connection ends are electrically connected to ends of the N impedance members in a one-to-one correspondence; and when the substrate is provided on the current sampling member, the N connection ends are electrically connected to the N sampling points in a one-to-one correspondence.

In an embodiment, the sampling points and connection ends are bonding pads.

In an embodiment, one of the sampling points and the connection ends are female connection sockets, and the other are male connection plugs.

In an embodiment, the impedance member includes a resistor.

In an embodiment, the impedance member comprises a microstrip line, and the substrate comprises a top wiring layer, a middle wiring layer and a bottom wiring layer provided from top to bottom; and
the microstrip line is provided on one of the top wiring layer, the middle wiring layer and the bottom wiring layer; and the connection end is provided on the bottom wiring layer or the top wiring layer.

The present application also provides an electric device, including the shunt as described in any one of the above.

The present application also provides an energy storage device, including the shunt as described in any one of the above.

The present application provides a shunt, which includes a current sampling member. The current sampling member is provided with a first connection segment and a second connection segment. N sampling points are provided on each of the first connection segment and the second connection segment. The N sampling points on the first connection segment and the N sampling points on the second connection segment are symmetrically provided along the midline of the current sampling member; and each of the sampling points is led out through an impedance member. Thus, in practical applications, when the two ends of the current sampling member are connected in series to the current loop to be tested, the problem of uneven current distribution flowing through the current sampling member caused by poor contact at both ends can be reduced through the above arrangement, thereby effectively improving the detection accuracy of the shunt.

### BRIEF DESCRIPTION OF THE DRAWINGS

In order to illustrate the technical solutions in the embodiments of the present application or in the related art more clearly, the following briefly introduces the accompanying drawings required for the description of the embodiments or the related art. Obviously, the drawings in the following description are only part of embodiments of the present application. For those skilled in the art, other drawings can also be obtained according to the structures shown in these drawings without any creative effort.
FIG. 1 is a schematic structural diagram of a shunt according to an embodiment of the present application.
FIG. 2 is a schematic structural diagram of the shunt according to an embodiment of the present application.
FIG. 3 is a schematic structural diagram of the shunt according to an embodiment of the present application.
FIG. 4 is a schematic structural diagram of the shunt according to an embodiment of the present application.
FIG. 5 is a schematic structural diagram of the shunt according to an embodiment of the present application.
FIG. 6 is a schematic structural diagram of the shunt according to an embodiment of the present application.
FIG. 7 is a schematic structural diagram of the shunt according to an embodiment of the present application.
FIG. 7A is a schematic structural diagram of a bottom wiring layer of a substrate of the shunt according to an embodiment of the present application.
FIG. 7B is a schematic structural diagram of a top wiring layer of the substrate of the shunt according to an embodiment of the present application.
FIG. 7C is a schematic structural diagram of a middle wiring layer of the substrate of the shunt according to an embodiment of the present application.
FIG. 7D is a schematic connection diagram of the substrate and a current sampling member of the shunt according to an embodiment of the present application.
FIG. 8 is a schematic current diagram of the shunt of the present application in a first current test.
FIG. 9 is a schematic current diagram of the shunt of the present application in a second current test.
FIG. 10 is a schematic current diagram of the shunt of the present application in a third current test.
FIG. 11 is a schematic current diagram of the shunt of the present application in a fourth current test.
FIG. 12 is a schematic current diagram of a shunt in prior art in the fourth current test.

Description of reference numbers:

**[Table 1]**

| reference number | name | reference number | name |
|---|---|---|---|
| 10 | current sampling member | 20 | sampling point |
| 30 | impedance member | 40 | substrate |
| 50 | wire bonding | 11 | first connection segment |
| 12 | second connection segment | 13 | current sensing member |
| 41 | bottom wiring layer of the substrate | 42 | top wiring layer of the substrate |
| 43 | middle wiring layer of the substrate | 401 | connection end |

The realization of the objective, functional characteristics, and advantages of the present application are further described with reference to the accompanying drawings.

### DETAILED DESCRIPTION OF THE EMBODIMENTS

The technical solutions of the embodiments of the present application will be described in more detail below with reference to the accompanying drawings. It is obvious that the embodiments to be described are only some rather than all of the embodiments of the present application. All other embodiments obtained by those skilled in the art based on the embodiments of the present application without creative efforts shall fall within the scope of the present application.

It should be noted that directional indications, such as up, down, left, right, front, back, etc., involved in the embodiments of the present application are only used to explain a certain posture as shown in the accompanying drawings. If the specific posture changes, the directional indication also changes accordingly.

In a current detection circuit, a shunt is generally used to be connected in series in a circuit loop to be tested. By detecting the voltage at the two connection ends of the shunt connected to the loop and the known impedance of the shunt, the current flowing through the shunt is calculated, thereby obtaining the current value in the circuit loop to be tested.

However, in practical applications, when the shunt is connected in series to the circuit loop to be tested, poor contact often occurs at the two connection ends of the shunt. For example, during welding, bubbles generated during welding cause the circuit loop to be tested and the connection ends of the shunt to be in contact only at partial positions. In the actual working process, this will lead to uneven current density distribution flowing through the shunt, which in turn causes a certain deviation between the sampled voltage value and the actual voltage value when sampling through the above method, thereby affecting the detection accuracy of the shunt.

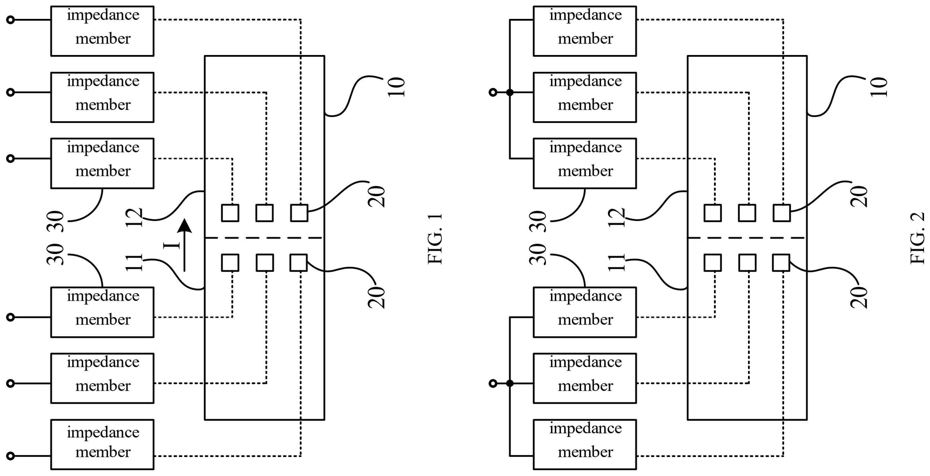

To this end, referring to FIG. 1, in an embodiment of the present application, the shunt includes a current sampling member 10.

The current sampling member 10 is provided with a first connection segment 11 and a second connection segment 12, and N sampling points 20 are provided on each of the first connection segment 11 and the second connection segment 12, where N is greater than 1.

The N sampling points 20 on the first connection segment 11 and the N sampling points 20 on the second connection segment 12 are symmetrically provided along the midline of the current sampling member 10, and each sampling point 20 is led out through an impedance member 30.

In this embodiment, the current sampling member 10 can be implemented by a current sensing resistor. The current sensing resistor can be divided into a first connection segment 11 and a second connection segment 12 on the left and right with the midline as the reference. An opening can be provided on the package of the first connection segment 11 or the second connection segment 12 corresponding to the position of the alloy in the actual current sampling member 10 to serve as the sampling point 20.

In an embodiment, the current sampling member 10 can also be composed of a current sensing resistor and conductive elements welded at both ends of the current sensing resistor. The sampling point 20 can be implemented in the form of a bonding pad, a socket, an electrode, etc. Meanwhile, the sampling point 20 can be provided at a position of the conductive element close to the current sensing resistor to reduce the influence of the impedance of the conductive element itself.

In this embodiment, each impedance member 30 can be electrically connected to an external output pin provided in the shunt, so that an external circuit can access the pin and read the value of the electrical signal output by the sampling point 20 through the impedance member 30. In an embodiment, the shunt can also be directly provided with a circuit module for processing the sampled electrical signal value, such as a main controller. The analog-to-digital converter (ADC) port on the main controller can be electrically connected to the impedance member 30 to detect the voltage value of the electrical signal output by the sampling point 20 through the impedance member 30, and directly calculate the result of the actual flowing current value before outputting it externally.

In this embodiment, the sampling points 20 on the first connection segment 11 and the sampling points 20 on the second connection segment 12 are symmetrically provided one by one along the midline of the current sampling member 10. Furthermore, the sampling points 20 of the same group (that is, the sampling points 20 on the first connection segment 11 and the sampling points 20 on the second connection segment 12 that need to be symmetrically provided) shall be symmetrically distributed with the midline of the regularly shaped alloy inside the current sampling member 10. It can be understood that if two sampling points 20 are not symmetrically distributed, it is equivalent to actively introducing new errors into the actual sampling result. In other words, due to the uneven current density distribution caused by the problem in the background art, if the sampling points 20 are asymmetric, the actual result will still be an uneven result.

In this embodiment, the resistance of any impedance member 30 must be greater than or equal to a certain preset resistance, such as 10 milliohms. Specifically, when the installation end of the current sensing member 13 is actually connected to the circuit to be tested, a position on the installation end to the sampling point 20 can be equivalent to a plurality of series-connected small resistors. Due to poor connection contact, the resistances of the plurality of series-connected small resistors from different points to the sampling point 20 are different, which leads to uneven current density distribution, that is, the actual voltage value on the sampling point 20 can only represent part of the flowing current. Therefore, in this embodiment, since the resistance of the impedance member 30 is greater than a certain preset resistance, that is, greater than the resistance of the above-mentioned small resistors, during the actual detection process, the voltage drop generated by the current flowing through the sampling point 20 is larger due to the existence of the impedance member 30 with a relatively large resistance, which can reduce the influence that the actual voltage value on the sampling point 20 can only represent part of the flowing current due to the uneven current distribution, thereby making the voltage value of the electrical signal output by the sampling point 20 closer to the voltage value of the electrical signal representing the actual current output, and further enabling the external circuit to more accurately calculate the actual current value flowing through the shunt when reading the sampling value. Thus, the present application effectively improves the detection accuracy of the shunt.

In this embodiment, there can be multiple groups of symmetric sampling points 20 on the current sampling. In an embodiment, the multiple groups of sampling points 20 can be distributed on the current sampling member 10 along the second direction, such as shown in FIG. 1. The second direction is perpendicular to the direction of the current flowing through the current sampling member 10. It can be understood that during the actual operation of the shunt, the current will flow through different positions of the current sampling member 10, such as the upper side or the lower side of the current sampling member 10. Therefore, through the above arrangement, during the process of the external circuit processing the data output by the shunt, more sampling values can be obtained, thereby obtaining a more accurate actual current value flowing through the current sensing member 13, and effectively improving the detection accuracy of the shunt.

Referring to FIG. 2, in an embodiment, the impedance member 30 is provided with a first end and a second end, and the first end of the impedance member 30 is connected to the corresponding sampling point 20. The second ends of the impedance members 30 correspondingly connected to all the sampling points 20 on the first connection segment 11 are electrically connected to each other. The second ends of the impedance members 30 correspondingly connected to all the sampling points 20 on the second connection segment 12 are electrically connected to each other. Through the above arrangement, in the actual package, the number of pins for the shunt to output sampling values externally can be reduced, thereby reducing the volume of the shunt.

In an embodiment, referring to FIG. 1, the second ends of the impedance members 30 correspondingly connected to all the sampling points 20 on the first connection segment 11 are provided at intervals from each other. The second ends of the impedance members 30 correspondingly connected to all the sampling points 20 on the second connection segment 12 are provided at intervals from each other. Through the above arrangement, the external circuit can process the electrical signals output by the sampling points 20 corresponding to different positions based on actual needs, thereby improving the adaptability of the shunt to the detection needs of the external circuit.

Meanwhile, in this embodiment, the resistance difference between the resistance of the impedance member 30 connected to the sampling point 20 on any first connection segment 11 and the resistance of the impedance member 30 connected to the sampling point 20 on the symmetric second connection segment 12 is less than or equal to a preset second resistance difference. For example, the resistance difference between the two impedance members 30 needs to be less than or equal to ±1% of the resistance of any one of the impedance members 30. Thus, during the sampling process, the artificial introduction of uneven current density distribution due to excessive resistance errors of the impedance members 30 on both sides can be avoided, which might affect the sampling accuracy.

Furthermore, the resistance difference between any two of the impedance members 30 needs to be less than or equal to a preset resistance difference. For example, the resistance difference between the two impedance members 30 needs to be less than or equal to ±1% of the resistance of any one of the impedance members 30. As can be seen from the embodiment in FIG. 2, the impedance members 30 corresponding to the sampling points 20 on the same connection segment are finally output in parallel. Therefore, if there is a difference in resistance between the impedance members 30 of different groups, it is equivalent to artificially introducing unnecessary errors into the electrical signal finally output in parallel, which may easily lead to a decrease in detection accuracy. In addition, it should be understood that in the prior art, there is a technical solution of setting impedance members 30 with corresponding resistances for sampling points 20 at different positions according to the actual current density on the current shunt to improve sampling accuracy. However, for the shunt of the present application, in the actual application environment, the personnel needs to install it in different electric devices or energy storage devices. There will also be contact problems between the shunt and the actual circuit to be tested. Meanwhile, during the long-term use of the electric device or the energy storage device, the working environment of the shunt will also undergo various changes.

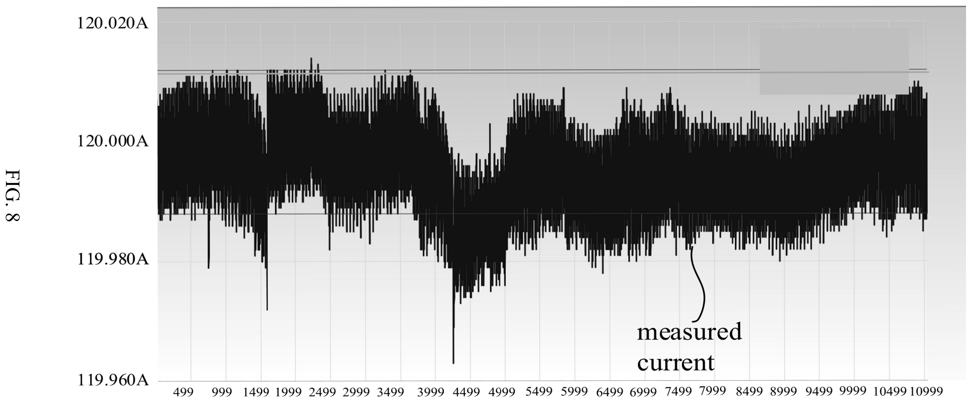

Specifically, referring to FIGS. 8 to 11, FIGS. 8-11 are schematic diagrams of current tests of the shunt of the present application under different installation conditions. The shunt used for the test has four groups of symmetric sampling points, and the resistance of each impedance member is 10mΩ±0.5%.

FIG. 8 is a test diagram of the two ends of the shunt soldered to the bonding pads of the printed circuit board assembly (PCBA) through reflow soldering. The specific detection data are as follows:

**[Table 2]**

| | | |
|---|---|---|
| measured current | 119.999A | |
| standard current | 119.99907A | |
| maximum measured current | 120.014A | error: 0.012% |
| minimum measured current | 119.963A | error: -0.030% |

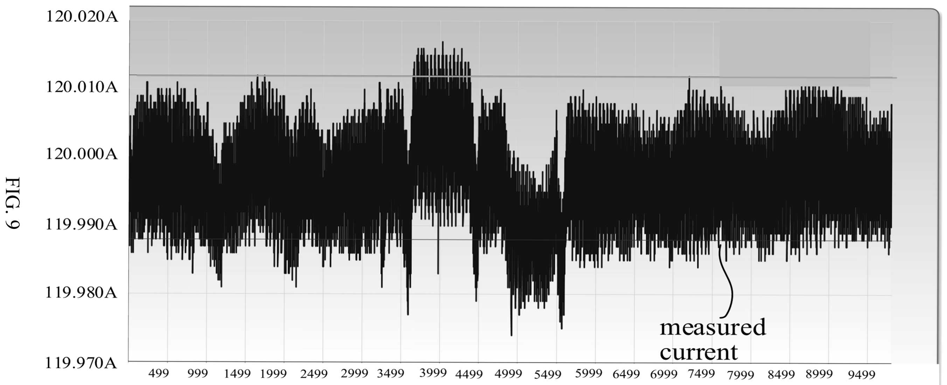

FIG. 9 is a test diagram of the two ends of the shunt soldered to the solder holes of the PCBA by wave soldering. The specific detection data are as follows:

**[Table 3]**

| | | |
|---|---|---|
| measured current | 119.990A | |
| standard current | 119.99895A | |
| maximum measured current | 120.017A | error: 0.015% |
| minimum measured current | 119.974A | error: -0.021% |

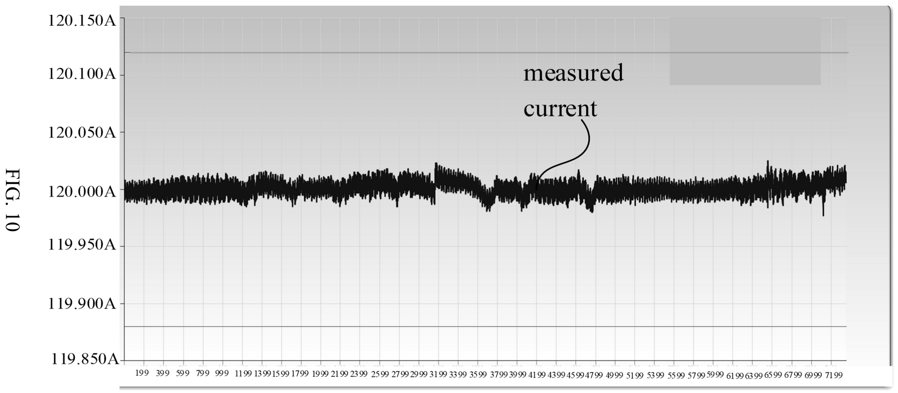

FIG. 10 is a test diagram of the two ends of the shunt fixed in the test loop by screws, with two installation holes. The specific detection data are as follows:

**[Table 4]**

| | | |
|---|---|---|
| measured current | 120.006A | |
| standard current | 119.99912A | |
| maximum measured current | 120.025A | error: 0.022% |
| minimum measured current | 119.977A | error: -0.018% |

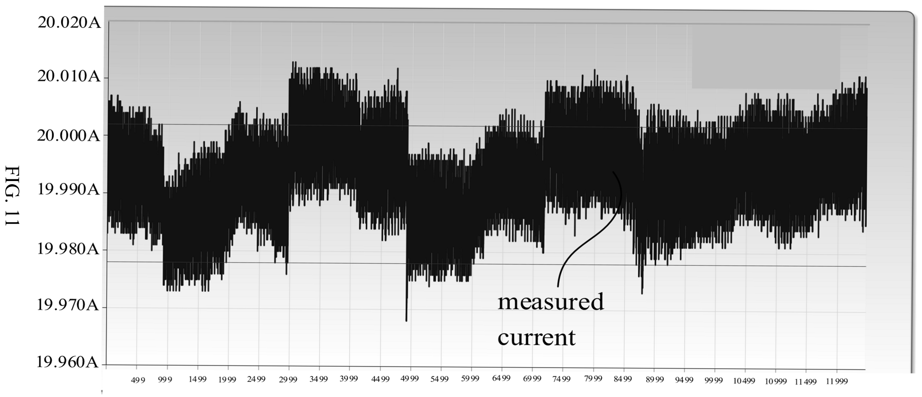

FIG. 11 is a test diagram of the two ends of the shunt fixed in the test loop by screws, with four installation holes. The specific detection data are as follows:

**[Table 5]**

| | | |
|---|---|---|
| measured current | 120.002A | |
| standard current | 119.99913A | |
| maximum measured current | 120.013A | error: 0.012% |
| minimum measured current | 119.968A | error: -0.026% |

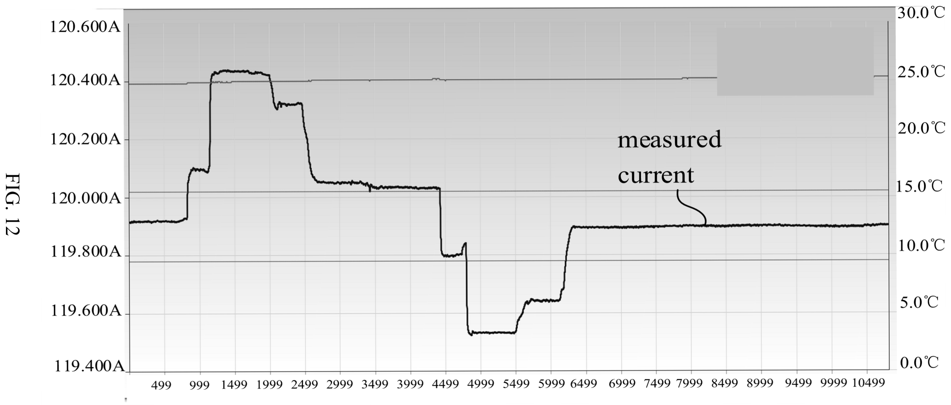

FIG. 12 is a schematic diagram of current detection of a shunt in the prior art (without the impedance member of the present application, and only two installation ends of the shunt are detected) under the same test environment as in FIG. 11. The specific detection data are as follows:

**[Table 6]**

| | | |
|---|---|---|
| measured current | 119.902A | |
| standard current | 120.00098A | |
| maximum measured current | 120.440A | error: 0.366% |
| minimum measured current | 119.523A | error: -0.398% |

It can be seen from FIGS. 11 and 12 that in the current test in the prior art, the error between the measured current and the standard current is close to 0.4%. However, when the shunt provided in the present application is detected under the same test environment, the detection error can be effectively reduced. Meanwhile, it can be seen from the contents of FIGS. 8 to 11 that when the resistance of the impedance member is 10mΩ±0.5%, that is, the resistance difference between any two impedance members is as small as possible, under different installation environments of the shunt, that is, under different conditions of uneven current density distribution, the error between the measured current detected by the shunt and the standard current is basically kept within ±0.03%. Therefore, in the present application, by setting the resistance difference between any two of the above impedance members 30 as small as possible, it can be effectively ensured that the detection accuracy of the shunt of the present application can still be maintained at a high level in different environments. Compared with the prior art, it has stronger adaptability to the use environment and use conditions.

The present application provides a shunt, which includes a current sampling member 10. The current sampling member 10 is provided with a first connection segment 11 and a second connection segment 12. N sampling points 20 are provided on each of the first connection segment 11 and the second connection segment 12. The N sampling points 20 on the first connection segment 11 and the N sampling points 20 on the second connection segment 12 are symmetrically provided along the midline of the current sampling member 10, and each sampling point 20 is led out through an impedance member 30. Thus, in practical applications, when the two ends of the current sampling member 10 are connected in series to the current loop to be tested, the problem of uneven current distribution flowing through the current sampling member 10 caused by poor contact at both ends can be reduced through the above arrangement, thereby effectively improving the detection accuracy of the shunt.

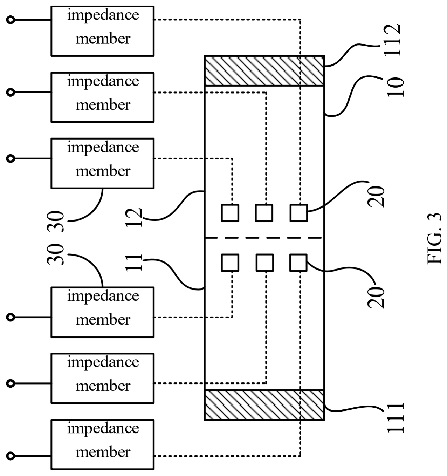

Referring to FIG. 3, in an embodiment of the present application, a first installation end is further provided on the first connection segment 11, and the first installation end is provided at intervals from the sampling points 20 on the first connection segment 11.

A second installation end is further provided on the second connection segment 12, and the second installation end is provided at intervals from the sampling points 20 on the second connection segment 12.

In this embodiment, the first installation end and the second installation end on the current sampling member 10 can be connected in series to the current loop to be tested through welding, plugging, etc. The first installation end and the second installation end can be implemented by metal electrodes, such as copperplated electrodes, nickel-plated electrodes and tin-plated electrodes stacked from the inside out. It can be understood that in practical applications, if the installation end is provided close to the sampling point 20 or at the same position, when the shunt is connected in series to the current loop to be tested, such as welded into the loop, the sampling point 20 on it will be covered by soldering tin. However, due to bubbles inside the soldering tin, the sampled position may not actually be connected to the soldering tin, that is, no current flows through the sampling point 20, which may easily cause greater errors and reduce the detection accuracy.

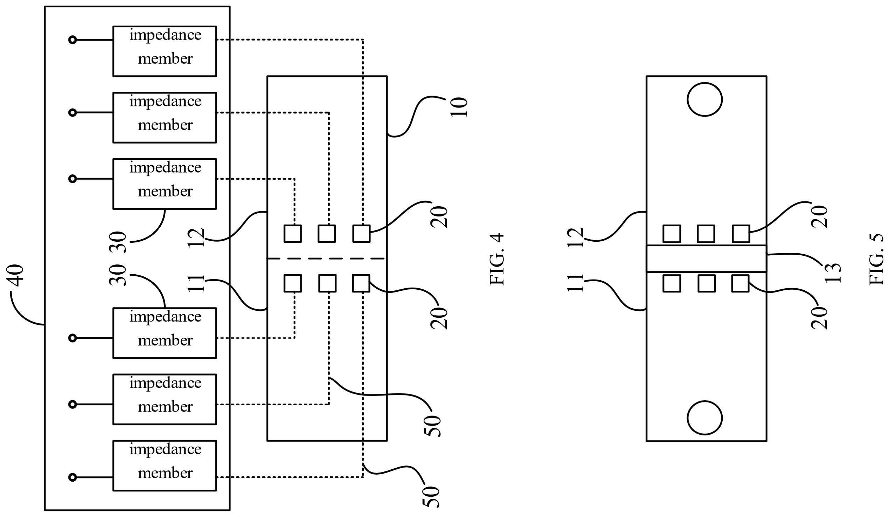

Referring to FIG. 4, in an embodiment of the present application, the shunt further includes a substrate 40.

The impedance member 30 is provided on the substrate 40.

The sampling points 20 on the current sampling member 10 are electrically connected to the substrate 40 through electrical connection wires.

In this embodiment, the substrate 40 can be implemented by a ceramic substrate 40, a glass fiber board, a paper substrate 40, a composite substrate 40, etc. Preferably, the substrate 40 can be implemented by a glass fiber board. Through the glass fiber board, the substrate 40 can maintain a complete mechanical structure during surface mount technology (SMT) patch furnace passing, thereby ensuring the reliability of the operation of the devices on the shunt. The substrate 40 can be provided with functional circuits such as a main control component, a wired/wireless communication module, and a temperature sensor module to correspondingly process and output the results of the values on the sampling points 20 collected through the impedance member 30. The substrate 40 can also be provided with only a plurality of pins extending out of the housing, and the plurality of pins are respectively connected to the first ends of the plurality of impedance members 30 in a one-to-one correspondence.

In an embodiment, the impedance member 30 can be provided on the substrate 40, and the sampling points 20 on the current sampling member 10 can be connected to the substrate 40 by wire bonding 50 to realize the electrical connection between the impedance member 30 on the substrate 40 and the corresponding sampling points 20.

Referring to FIG. 5, in an embodiment of the present application, the current sampling member 10 includes a current sensing member 13, a first conductive member and a second conductive member; the first conductive member is the first connection segment 11; and the second conductive member is the second connection segment 12;
The first conductive member and the second conductive member are respectively electrically connected to the current sensing member 13.

In this embodiment, the first conductive member and the second conductive member can be made of metal materials, such as copper, silver, iron, or alloy materials. The current sensing member 13 can be implemented by a current sensing resistor made of alloy material. The sampling points 20 can be respectively provided on the first conductive member and the second conductive member. In an embodiment, the sampling points 20 on the first conductive member and the second conductive member are both provided at positions close to the current sensing resistor, thereby reducing the influence of the conductive member on the electrical signal output by the sampling points 20.

In this embodiment, mounting holes are provided on the first conductive member and/or the second conductive member. In an embodiment, the sampling points 20 and the mounting holes on the same conductive member are provided at intervals. For example, the sampling points 20 are provided at the first end of the conductive member close to the current sensing resistor, and the mounting holes are provided at the second end far from the current sensing resistor. In an embodiment, the number of mounting holes can be at least one, and the sizes and types of different mounting holes can be different. In an embodiment, the shapes of the first conductive member and the second conductive member can be cuboid, arc, etc., and the shapes of the first conductive member and the second conductive member can also be inconsistent. Thus, through the mounting holes, the entire shunt can be fixedly connected in series to the path between the power supply end and the load. For example, when installed in a car, the mounting hole on one conductive member is fixedly and electrically connected to the output end of the distribution box through a screw, and the other end is fixedly connected to the power supply end of the load through a screw. The current output by the power supply end will flow through the first conductive member, the current sensing member 13 and the second conductive member to the load. Meanwhile, the two conductive members can also help reduce the temperature on the current sensing member 13, improve the heat dissipation efficiency of the shunt, and thus ensure the reliability of the operation of the shunt.

In addition, it should be understood that as can be seen from the above content, the mounting holes on the first conductive member and the second conductive member can be connected to the power supply end or the load end by screwing. However, in actual situations, when the screw is fixed on the mounting hole, due to the structural differences of the screw itself, the force of tightening the screw, etc., the screw itself can only be in partial contact with the conductive member around the mounting hole, that is, the contact is uneven. Meanwhile, the material distribution of the first conductive member and the second conductive member themselves is also uneven, and the welding with the current sensing member is not uniform. The above problems will lead to uneven current density distribution of the actual current flowing through the shunt, which in turn causes errors in sampling and reduces detection accuracy. In the present application, since the impedance member 30 in the above embodiment is provided in the shunt, during the actual operation of the shunt, the impedance member 30 can also effectively solve the problem of low detection accuracy caused by the above connection problems and the material problems of the conductive member, and effectively reduce the detection accuracy deviation caused by the above differences.

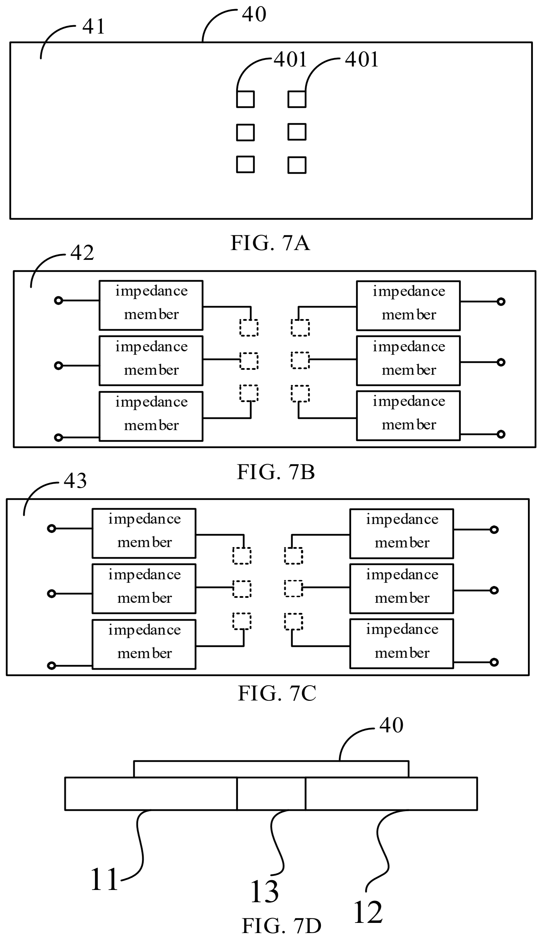

Referring to FIG. 5 and FIG. 7, in an embodiment of the present application, the shunt further includes a substrate 40.

The impedance member 30 is provided on the substrate 40, and the substrate 40 is mounted on the current sampling member 10.

N connection ends 401 are provided on the side of the substrate 40 facing the current sampling member 10 corresponding to the positions of the sampling points 20, and the N connection ends 401 are electrically connected to one ends of the N impedance members 30 in a one-to-one correspondence. When the substrate 40 is provided on the current sampling member 10, the N connection ends 401 are electrically connected to the N sampling points 20 in a one-to-one correspondence.

In this embodiment, the substrate 40 can be implemented by a ceramic substrate 40, a glass fiber board, a paper substrate 40, a composite substrate 40, etc. Preferably, the substrate 40 can be implemented by a glass fiber board. Through the glass fiber board, the substrate 40 can maintain a complete mechanical structure during SMT patch furnace passing, thereby ensuring the reliability of the operation of the devices on the shunt. The substrate 40 can be provided with functional circuits such as a main control component, a wired/wireless communication module, and a temperature sensor module to correspondingly process and output the results of the values on the sampling points 20 collected through the impedance member 30. The substrate 40 can also be provided with only a plurality of pins extending out of the housing, and the plurality of pins are respectively connected to the first ends of the plurality of impedance members 30 in a one-to-one correspondence.

In this embodiment, the impedance member 30 and the connection end 401 can be provided on one side of the substrate 40. In an embodiment, referring to FIG. 7A and FIG. 7B, the impedance member 30 and the connection end 401 are respectively provided on both sides of the substrate 40. For example, the connection end 401 in FIG. 7A is provided on the bottom wiring layer 41 of the substrate 40, and the impedance member 30 in FIG. 7B is provided on the top wiring layer 42 of the substrate 40. The impedance member 30 and the corresponding connection end 401 can be electrically connected through the wiring laid on the substrate 40 and the via holes provided on the substrate 40.

In this embodiment, referring to FIG. 7D, the substrate 40 and the current sampling board can be stacked up and down to reduce the wiring area inside the shunt package. The electrical signal output by the sampling point 20 can be output externally through the connection end 401 correspondingly connected to the sampling point 20 and the impedance member 30 correspondingly connected to the connection end 401.

In an embodiment, the substrate 40 and the current sampling member 10 can be fixedly connected by welding. Specifically, both the sampling points 20 and the connection ends 401 can be implemented by bonding pads. The shape of the bonding pad can be square, circular, etc. It can be understood that in order to reduce the introduction of new error factors due to inconsistent connection impedance of the sampling points 20, the errors between the shapes and bonding pad thicknesses of the symmetric sampling points 20 on the first conductive member and the second conductive member should be as small as possible, preferably consistent. Meanwhile, it can be understood that the errors between the shapes and bonding pad thicknesses of the bonding pads of the two corresponding connection ends 401 should be as small as possible, preferably consistent. Thus, when the bonding pads of the connection ends 401 on the substrate 40 are welded to the sampling points 20 of the current sampling member 10 in a one-to-one correspondence, the difference in connection impedance between different groups of sampling points 20 and connection ends 401 can be minimized, thereby ensuring the accuracy of detecting the current of the shunt while simplifying the overall structure of the current device.

In an embodiment, the substrate 40 and the current sampling member 10 can also be fixed and electrically connected through a connector. Specifically, one of the sampling points 20 and the connection ends 401 is a female connection socket, and the other is a male connection plug. The structures of the female connection socket and the male connection plug are consistent, such as Dupont female socket and Dupont male plug, board-to-board connector, etc. Thus, the connection through the connector can reduce the assembly difficulty of the substrate and the current sampling member 10, and effectively improve the assembly and production cost of the shunt.

Through the above arrangement, the wiring area inside the shunt package housing can be effectively reduced, thereby simplifying the overall volume of the shunt. Meanwhile, in this embodiment, the wiring area is reduced by stacking the substrate 40 and the current sensing member 13. Therefore, when the sampling points 20 and the connection ends 401 are connected, new connection impedance will inevitably be introduced. However, due to process problems, such as inevitable bubbles during welding or the influence of errors of the connectors themselves, there will also be a certain gap between the actual connection impedances. In the present application, since the impedance member 30 in the above embodiment is provided on the substrate 40, during the actual operation of the shunt, the impedance member 30 can also effectively solve the problem of low detection accuracy caused by the connection impedance difference brought by the above structure, and effectively reduce the detection accuracy deviation caused by the structural difference.

In addition, in an embodiment, referring to FIG. 7A and FIG. 7B, the impedance member 30 can be implemented by a resistor provided on the substrate 40. Specifically, all resistors can be resistors of the same package type, such as 0805 resistors, 0603 resistors and 0402 resistors.

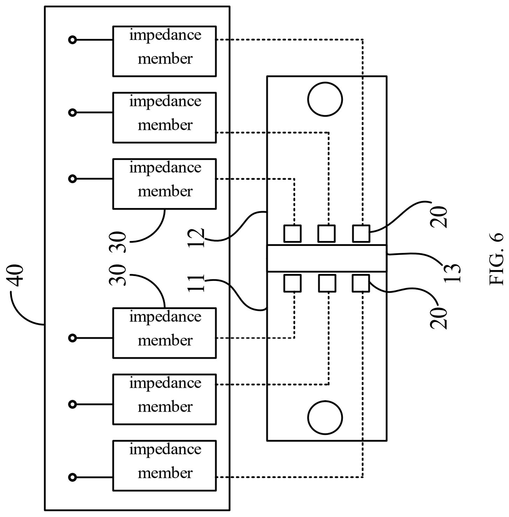

In another embodiment, referring to FIGS. 6 to 7, the impedance member 30 includes a microstrip line; and the substrate 40 includes a top wiring layer 42, a middle wiring layer 43 and a bottom wiring layer 41 provided from top to bottom.

The microstrip line is provided on one of the top wiring layer 42, the middle wiring layer 43 and the bottom wiring layer 41; and the connection end is provided on the bottom wiring layer or the top wiring layer.

It can be understood that the substrate 40 can be a multi-layer board, that is, in addition to the wiring on both sides, wiring can also be performed on the middle layer inside the substrate 40.

In an embodiment, each microstrip line can be respectively provided on one of the top wiring layer 42, the middle wiring layer 43 and the bottom wiring layer 41 to reduce the wiring area on the substrate. Preferably, each microstrip line is provided on the same wiring layer, so that the second end of each microstrip line can be led out from the same layer through the electrical connection wires and/or via holes on the substrate and connected to external pins or devices on the substrate, thereby ensuring that the resistance difference between the electrical connection wires and/or via holes corresponding to any two microstrip lines can be as small as possible, and further ensuring the detection accuracy of the shunt.

Specifically, in this embodiment, referring to FIG. 7A, the microstrip lines in FIG. 7A are all provided on the middle wiring layer 43. On the periphery of the connection end 401 or on the connection end 401 in FIG. 7A, via holes electrically connected to the connection end 401 can be provided to establish an electrical connection path between the microstrip lines corresponding to the connection end 401. The position of the via hole can be exactly on the microstrip line, such as the position of the first end of the microstrip line, or on the periphery of the microstrip line and connected to the corresponding microstrip line through the electrical connection wire on the substrate. A second via hole is also provided at the position of the second end of each microstrip line or beside the second end, so that the electrical signal output by the sampling point 20 can be output to the device on the substrate 40 connected to the second via hole through the via hole, the first end of the microstrip line, the second end of the microstrip line, and the second via hole.

In an embodiment, the errors between the shapes and thicknesses of the microstrip lines corresponding to the symmetric sampling points 20 should be less than the preset error. Preferably, the shapes and thicknesses of the two microstrip lines are completely consistent. Meanwhile, the materials of the two microstrip lines should also be completely consistent, so as to ensure that the error between the resistances of the two microstrip lines corresponding to the symmetric sampling points 20 is less than the preset resistance error of the above embodiment, so as to ensure the accuracy of detecting the current of the shunt. Preferably, the shapes and thicknesses of all microstrip lines can be completely consistent. Thus, through the above arrangement, the wiring area occupied by the devices on the surface of the substrate 40 can be reduced, thereby further simplifying the volume of the shunt.

The present application also provides an electric device, including the shunt as described in any one of the above.

In this embodiment, the electric device can be a new energy vehicle, a motor assembly, etc.

It should be noted that since the electric device of the present application is based on the above-mentioned shunt, the embodiments of the electric device of the present application include all the technical solutions of all the embodiments of the above-mentioned shunt, and the achieved technical effects are also completely the same, which will not be repeated here.

The present application also provides an energy storage device, including the shunt as described in any one of the above.

In this embodiment, the energy storage device can be an integrated energy storage machine, a battery pack, a mobile charging vehicle, an outdoor power supply, etc.

It should be noted that since the energy storage device of the present application is based on the above-mentioned shunt, the embodiments of the energy storage device of the present application include all the technical solutions of all the embodiments of the above-mentioned shunt, and the achieved technical effects are also completely the same, which will not be repeated here.

The above contents are only optional embodiments of the present application, and are not intended to limit the scope of the present application. Under the application concept of the present application, any equivalent structural transformation made through the contents of the specification and drawings of the present application, or direct/indirect application in other related technical fields, is included in the protection scope of the present application.

## Claims

1. A shunt, **characterized by** comprising:
a current sampling member provided with a first connection segment and a second connection segment, wherein N sampling points are provided on each of the first connection segment and the second connection segment, and N is greater than 1;
wherein the N sampling points on the first connection segment and the N sampling points on the second connection segment are symmetrically provided along a midline of the current sampling member, and each of the N sampling points is led out through an impedance member.

2. The shunt according to claim 1, wherein a resistance difference between any two impedance members is less than or equal to a preset first resistance difference, and a resistance of any one of impedance members is greater than or equal to 10 milliohms.

3. The shunt according to claim 2, wherein the resistance of any one of the impedance members is less than or equal to 1000 ohms.

4. The shunt according to claim 1, wherein a resistance difference between a resistance of the impedance member connected to any one of sampling points on the first connection segment and a resistance of the impedance member connected to a sampling point on the second connection segment symmetric with the any one of sampling points on the first connection segment is less than or equal to a preset second resistance difference.

5. The shunt according to claim 1, wherein:
the impedance member is provided with a first end and a second end, and the first end of the impedance member is connected to a corresponding sampling point;
second ends of impedance members connected to all sampling points on the first connection segment are electrically connected to each other; and second ends of impedance members connected to all sampling points on the second connection segment are electrically connected to each other; or
second ends of impedance members connected to all the sampling points on the first connection segment are provided at intervals from each other; and second ends of impedance members connected to all the sampling points on the second connection segment are provided at intervals from each other.

6. The shunt according to claim 1, wherein:
a first installation end is further provided on the first connection segment, and the first installation end is spaced apart from sampling points on the first connection segment; and
a second installation end is further provided on the second connection segment, and the second installation end is spaced apart from sampling points on the first connection segment.

7. The shunt according to claim 1, further comprising:
a substrate, wherein the impedance member is provided on the substrate;
wherein sampling points on the current sampling member are electrically connected to the substrate through electrical connection wires.

8. The shunt according to claim 1, wherein:
the current sampling member comprises a current sensing member, a first conductive member and a second conductive member; the first conductive member is the first connection segment; and the second conductive member is the second connection segment; and
the first conductive member and the second conductive member are respectively electrically connected to the current sensing member; and mounting holes are provided on the first conductive member and/or the second conductive member.

9. The shunt according to claim 8, further comprising:
a substrate, wherein the impedance member is provided on the substrate, and the substrate is mounted on the current sampling member;
wherein N connection ends corresponding to positions of the sampling points are provided on one side of the substrate facing the current sampling member, and the N connection ends are electrically connected to ends of the N impedance members in a one-to-one correspondence; and when the substrate is provided on the current sampling member, the N connection ends are electrically connected to the N sampling points in a one-to-one correspondence.

10. The shunt according to claim 9, wherein the sampling points and connection ends are bonding pads.

11. The shunt according to claim 9, wherein one of the sampling points and the connection ends are female connection sockets, and the other are male connection plugs.

12. The shunt according to claim 9, wherein the impedance member comprises a resistor.

13. The shunt according to claim 9, wherein:
the impedance member comprises a microstrip line, and the substrate comprises a top wiring layer, a middle wiring layer and a bottom wiring layer provided from top to bottom; and
the microstrip line is provided on one of the top wiring layer, the middle wiring layer and the bottom wiring layer; and the connection end is provided on the bottom wiring layer or the top wiring layer.

14. An electric device, **characterized by** comprising the shunt according to any one of claims 1 to 13.

15. An energy storage device, **characterized by** comprising the shunt according to any one of claims 1 to 13.
